(19) Europäisches Patentamt
European Patent Office
Office européen des brevets

(11) **EP 4 636 413 A1**

(12) **EUROPEAN PATENT APPLICATION**

(43) Date of publication:
**22.10.2025 Bulletin 2025/43**

(21) Application number: 24171373.4

(22) Date of filing: **19.04.2024**

(51) International Patent Classification (IPC):
*G01R 31/00* (2006.01)     *G01R 31/36* (2020.01)
*G01R 31/389* (2019.01)    *G01R 31/396* (2019.01)
*B60L 3/00* (2019.01)      *H02J 7/00* (2006.01)

(52) Cooperative Patent Classification (CPC):
**H02J 7/0029; B60L 3/0046; G01R 31/005;
G01R 31/006; G01R 31/36; G01R 31/389;
G01R 31/396; H02J 7/0047; H02J 7/0048**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **VOLVO TRUCK CORPORATION**
**405 08 Göteborg (SE)**

(72) Inventors:
• **RAY, Dripta**
  **412 76 GÖTEBORG (SE)**
• **SINGH, Shailesh**
  **417 47 GÖTEBORG (SE)**
• **ALTAF, Faisal**
  **421 43 VÄSTRA FRÖLUNDA (SE)**
• **LILLMAA, Henri**
  **463 72 LÖDÖSE (SE)**

(74) Representative: **Kransell & Wennborg KB**
**P.O. Box 2096**
**403 12 Göteborg (SE)**

(54) **POWER PATH FAULT DETECTION IN AN ENERGY STORAGE SYSTEM**

(57)     A device (100) for power path fault detection in an energy storage system, ESS, (130) is provided. The device is configured to obtain values (120) for a parameter of energy storage elements (such as battery packs; 132-1 to 130-N) of the ESS; to determine a deviation of the value of a first energy storage element (132-i) from an aggregate function value, wherein the aggregate function value is formed based on values of the parameter for one or more other energy storage elements than the first energy storage element. The device is configured to determine that the deviation is beyond a first threshold value and, in response thereto, detect a power path fault pertinent to the first energy storage element. A corresponding method, ESS, vehicle, computer program and storage medium are also provided.

*Fig. 1*

## Description

## TECHNICAL FIELD

The disclosure relates generally to an energy storage system (ESS), such as a plurality of battery packs provided in an electric vehicle. In particular aspects, the disclosure relates to detection of power path faults (such as an interconnection fault between a battery pack and a high-voltage distribution box, or similar) in such a system. The disclosure can be applied to heavy-duty vehicles, such as trucks, buses, and construction equipment, among other vehicle types. Although the disclosure may be described with respect to a particular vehicle, the disclosure is not restricted to any particular vehicle.

## BACKGROUND

In an energy storage system (ESS), such as a plurality of battery packs connected together to provide power for the propulsion of an electric vehicle, there may be many potential points of failure (i.e. faults) between e.g. a battery pack and a high-voltage distribution/junction box. Examples of such faults, referred to as power path faults, include disconnected or dislocated connectors/contactors, busbar faults, and similar, which may lead to loss of conductivity, increase in connection resistance and/or arcing between connecting surfaces. In some scenarios, such faults may lead to an increase in temperature and/or other thermal event, and a risk of e.g. igniting a fire within the ESS.

The present disclosure aims at providing a solution for monitoring the ESS and to detect power path faults therein, such that e.g. a faulty battery pack or similar may be isolated such that the above-mentioned risks are mitigated.

## SUMMARY

According to a first aspect of the present disclosure, there is provided a device for power path fault detection in an energy storage system (ESS). The device includes circuitry configured to obtain, during charging or discharging of an ESS, values for (e.g. same) one or more parameters for each energy storage element of a plurality of energy storage elements of the ESS. The circuitry is configured to determine, for at least one parameter of the one or more parameters, a deviation of the value of the at least one parameter for a first energy storage element of the plurality of energy storage elements from an aggregate function value. The aggregate function value is formed based on values of at least one parameter of the one or more parameters for one or more other energy storage elements of the plurality of energy storage elements than the first energy storage element. The circuitry is further configured to determine that the deviation is beyond a first threshold value and, in response thereto, detect a power path fault pertinent to the first energy storage element. The circuitry may be processing circuitry forming part of a computer system, or similar, or be implemented using integrated circuits (ICs) only, e.g. without software/program code.

The first aspect of the disclosure may seek to solve the problem of power path fault detection in an ESS, by comparing how one or more parameter values of a first energy storage element evolves in comparison with those of one or more other energy storage elements. A technical benefit may include that by detecting that the one or more parameter values of the first energy storage element starts to deviate from those of the other energy storage elements, there is likely something wrong with or in the vicinity of the first energy storage element, which may be used as an indication of a potential power path fault. The power path fault may thus be identified/detected, and handled appropriately. This may for example reduce the risk of increased temperature and eventually fire or other thermal events due to such a power path fault. As used herein, an "energy storage element" may be a battery cell, a battery module including multiple battery cells, a batter pack including one or more battery modules (or multiple battery cells, if using e.g. a cell-to-pack architecture), or any other structure for storing electrical energy and which is interconnected to direct power to/-from the energy storage element to some other part of the ESS, such as a high-voltage junction/connection box or similar. The at least one parameter for the first energy storage element may be the same at least one parameter that is used/checked for the other energy storage elements, but not necessarily. Combinations of one or more parameters for the first energy storage element may also be checked against aggregates of one or more (same or different) parameters for the other energy storage elements. As used herein, that a value is "beyond a threshold value" means that the value is e.g. larger than a positive threshold value, or that e.g. the value is smaller than a negative threshold value.

Optionally in some examples, including in at least one preferred example, determining the deviation may include taking into account values for the at least one parameter for the first energy storage element and/or for the one or more other energy storage elements for multiple time instances. A technical benefit may include that by so doing, time-filtering or similar of the parameter values may be performed in order to reduce the effect of e.g. noise or other artifacts in the values that may be due to other causes than an actual power path fault.

Optionally in some examples, including in at least one preferred example, detecting the power path fault may further include determining that the value of the at least one parameter for the first energy storage element is either bounded by or beyond a second threshold value. A technical benefit may include that the power path fault may be detected with less uncertainty due to the requirement of also needing to fulfill the condition pertinent to the second threshold value.

Optionally in some examples, including in at least one preferred example, the at least one parameter for the first energy storage element may include State-of-Charge, SoC. A technical benefit may include that the SoC of a first energy storage element starting to deviate from e.g. an average SoC of the other energy storage elements may serve as an indication that something is wrong with the first energy storage element.

Optionally in some examples, including in at least one preferred example, the at least one parameter of the first energy storage element may include voltage. A technical benefit may include that the voltage of a first energy storage element starting to deviate from e.g. an average voltage of the other energy storage elements may serve as an indication that something is wrong with the first energy storage element.

Optionally in some examples, including in at least one preferred example, the voltage may be one or more of battery cell voltage, battery pack voltage, battery pack link voltage, and battery pack voltage to battery pack link voltage difference. A technical benefit may include that voltage deviation may indicate several types of power path faults, as will be exemplified in more detail later herein.

Optionally in some examples, including in at least one preferred example, the at least one parameter for the first energy storage element may include internal impedance/resistance. A technical benefit may include that deviation in resistance between a first energy storage element and the others may serve as an indication that something is wrong with the first energy storage element.

Optionally in some examples, including in at least one preferred example, the internal impedance/resistance may be or include direct current internal resistance, DCIR. A technical benefit may be that such DCIR may be particularly useful to indicate potential power path faults. Alternatively or in addition, as also envisaged herein, other example dynamic resistances may serve as indicators, including e.g. instantaneous resistance or resistance over a certain time horizon of a current pulse, or similar.

Optionally in some examples, including in at least one preferred example, the at least one parameter for the first energy storage element may include an impedance/resistance of an interconnect, wherein the interconnect connects the first energy storage element to one or more of the other one or more energy storage elements. A technical benefit may include that power path faults pertinent to such interconnects may thus also be detected.

Optionally in some examples, including in at least one preferred example, the at least one parameter for the first energy storage element may include current. A technical benefit may include that power path faults affecting the current of/through the first energy storage element may thus be detected.

Optionally in some examples, including in at least one preferred example, the device may be further configured to determine (such) a deviation for each of a plurality of different parameters or parameter combinations for the first energy storage element, and to detect the power path fault in response to determining that each of the deviations is beyond a respective first threshold value. A technical benefit may include that the power path fault may be detected with less uncertainty, as detecting simultaneous deviations of multiple parameters or parameter combinations would with greater certainty indicate that there is a power path fault.

Optionally in some examples, including in at least one preferred example, the plurality of different parameters for the first energy storage element may include at least two of voltage, current, SoC and internal impedance. A technical benefit may include that such combinations may be particularly useful for detecting power path faults, if envisaged that a power path fault is likely to affect at least two of these parameters simultaneously.

Optionally in some examples, including in at least one preferred example, the aggregate function may include an average of the at least one parameter for the one or more other energy storage elements. A technical benefit may include that an average of a parameter among several energy storage elements may serve as a good indicator of how things are to be in case of no power path fault, and in that the deviation of the parameter for the first energy storage element from such an aggregate function value is thus a good indicator that something is wrong with the first energy storage element.

Optionally in some examples, including in at least one preferred example, the aggregate function value may include a minimum or maximum of the at least one parameter for the one or more other energy storage elements. A technical benefit may include that such an aggregate function may also serve as a good indicator of a "normal state" of the energy storage elements, and be used to detect when the parameter value(s) of the first energy storage element start(s) to deviate therefrom.

Optionally in some examples, including in at least one preferred example, the plurality of energy storage elements may be a plurality of battery packs.

Optionally in some examples, including in at least one preferred example, the plurality of energy storage elements may be a plurality of battery cells.

Optionally in some examples, including in at least one preferred example, the plurality of energy storage elements may be a plurality of battery modules.

Optionally in some examples, including in at least one preferred example, the device may be further configured to, in response to detecting the power path fault, trigger or cause a disconnection of the first energy storage element. A technical benefit may include that by disconnecting the first energy storage element from e.g. the other energy storage elements and/or from the ESS as a whole, the power path fault may be isolated and not allowed to cause further damage to other parts of the ESS. In some examples, in response to detecting the power path fault, the device may be configured to first reduce (or cause a reduction of) or stop (or cause a stopping of) a current through e.g. a contactor used to disconnect the first energy storage element before such a contactor is opened, in order to avoid causing unnecessary wear of the contactor due to arching or similar that may otherwise occur if attempting to open a contactor while carrying larger current.

Optionally in some examples, including in at least one preferred example, the device may be further configured to, in response to detecting the power path fault, trigger or cause a warning signal to an operator of the ESS. A technical benefit may include that the operator can then be made aware of the fault, and enabled to take appropriate action. For example, if the ESS is provided as part of an electric vehicle, a warning signal may be provided to a driver of the vehicle, such that the driver may stop the vehicle, call for service, drive the vehicle to a workshop, perform road-side service, and/or similar.

According to a second aspect of the present disclosure, there is provided an energy storage system (ESS), including a plurality of energy storage elements and the device of the first aspect (or any example thereof), for detecting a power path fault pertinent to at least one of the energy storage elements. The second aspect may seek to solve a same problem as the first aspect, namely that of how to detect power path faults in an ESS. A technical benefit may include that by incorporating the device of the first aspect, the ESS can be made safer and more reliable.

According to a third aspect of the present disclosure, there is provided a vehicle, such as a heavy(-duty) vehicle. The vehicle includes the energy storage system (ESS) of the second aspect. The vehicle may be an electric or hybrid-electric vehicle, wherein the ESS provides power to an electric or hybrid-electric traction/-propulsion of the vehicle. The third aspect may seek to solve the same problem as that of the first and second aspects. A technical benefit may include that by including the device of the first aspect, the vehicle can be made safer and more reliable as power path faults in its ESS may be detected more reliably.

According to a fourth aspect of the present disclosure, there is provided a (computer-implemented) method of detecting a power path fault in an energy storage system (ESS). The method may be performed by circuitry such as that of the device of the first aspect (wherein the circuitry may for example be processing circuitry of a computer system including, or included as part of, the device). The method includes i) obtaining, by the circuitry and during charging or discharging of an energy storage system, ESS, values for same one or more parameters for each energy storage element of a plurality of energy storage elements of the ESS; ii) determining, by the circuitry and for at least one parameter of the one or more parameters, a deviation of the value of the at least one parameter for a first energy storage element of the plurality of energy storage elements from an aggregate function value, including forming the aggregate function value based on values of at least one parameter of the one or more parameters for one or more other energy storage elements of the plurality of energy storage elements than the first energy storage element; and iii) determining, by the circuitry, that the deviation is beyond a first threshold value and, in response thereto, detecting a power path fault pertinent to the first energy storage element. The method of the fourth aspect may thus be performed by the device of the first aspect, and may seek to solve a same problem as the device, with the same technical benefits as already described referencing the device of the first aspect.

According to a fifth aspect of the present disclosure, there is provided a computer program or computer program product including computer program code for performing, when executed by e.g. processing circuitry of a computer system (including, or included as part of, e.g. the device of the first aspect), the method of the fourth aspect.

According to a sixth aspect of the present disclosure, there is provided a computer-readable storage medium including instructions, which when executed by such processing circuitry, cause the processing circuitry to perform the method of the fourth aspect. The computer-readable storage medium may be non-transitory.

According to a seventh aspect of the present disclosure, there is provided a computer program product, including a computer-readable storage medium on which the computer program of the fifth aspect is stored. The computer-readable storage medium may be non-transitory.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

FIG. 1 schematically illustrates examples of an energy storage system (ESS) and device for power path fault detection, according to one or more examples of the present disclosure.

FIG. 2 schematically illustrates a flowchart of an example (computer-implemented) method for power path fault detection in an ESS, according to one or more examples of the present disclosure.

**FIGS. 3A to 3G** schematically illustrate various examples of logic building blocks usable to construct the functionality of the envisaged device, according to one or more examples of the present disclosure.

**FIG. 4A** schematically illustrates an example vehicle including the ESS, according to one or more examples of the present disclosure.

**FIG. 4B** schematically illustrates an example ESS as part of a battery bank, according to one or more examples of the present disclosure.

**FIG. 5** illustrates a schematic diagram of an example computer system for implementing examples disclosed herein, according to one or more examples of the present disclosure.

## DETAILED DESCRIPTION

The detailed description set forth below provides information and examples of the disclosed technology with sufficient detail to enable those skilled in the art to practice the disclosure.

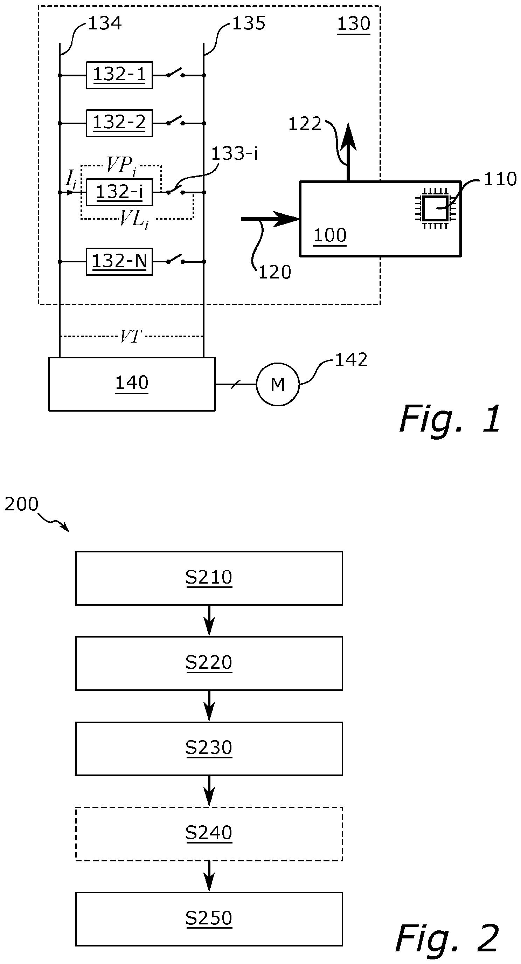

With reference to FIGS. 1 and 2, how the present disclosure envisages to more accurately detect power path faults in an energy storage system will now be described in more detail. As envisaged herein, an energy storage system is a collection multiple energy storage elements, wherein an "energy storage element" may for example be a battery cell, a battery module (including multiple battery cells), a battery pack (including e.g. multiple battery modules or at least multiple battery cells), and similar. In what follows, for illustrative purposes only, it will be assumed that the energy storage element is a battery pack If the energy storage element is instead something else, such as a battery module or battery pack, it is envisaged that the envisaged device may be configured accordingly.

**FIG. 1** is a block diagram that schematically illustrates a device 100 for power path fault detection as well as an example ESS 130. The device 100 may form part of the ESS 130 itself, or may be provided separately to the ESS 130.

**FIG. 2** schematically illustrates a flowchart of an example method 200 of power path fault detection, such as performed by the device 100.

The device 100 includes circuitry 110 that is configured to perform the various operations described below. The circuitry 110 may be processing circuitry, and the device may form part of or include a computer system. It is also envisaged that in some examples, the circuitry may instead be formed by e.g. a plurality of integrated circuits which do not depend on e.g. execution of software/program code in order to perform the operations described below.

The device 100 is configured to receive one or more inputs 120 from the ESS 130, more in particular from a plurality of energy storage elements of the ESS 130. As mentioned above, for illustrative purposes in particular, the energy storage elements of the ESS 130 are battery packs 132-1 to 132-N, where N is an integer indicating the total number of such battery packs. In this particular examples, the battery packs 132-1 to 132-N are connected in parallel to first and second conductors 134 and 135, respectively. The conductors 134 and 135 may for example be busbars, or similar. Each i:th battery pack 132-i may for example be connected to one of the conductors 134 and 135 via at least one contactor (or connector) 133-i, such as e.g. at least one switching elements, circuit breaker, or similar. The contactor 133-i may be mechanical or semiconductor-based, and may be controlled to either connect or disconnect the battery pack 132-i from the corresponding conductor 134 and/or 135. The contactors 134 and 135 are in turn connected to for example a high-voltage junction/connector box, power inverter, or similar, here illustrated by the box 140. The box 140 may represent e.g. all circuitry required to convert the power received from the battery packs 132-1 to 132-N to a form suitable for powering an electrical machine, such as e.g. an electric motor 142.

Based on the one or more inputs 120, the device 100 is configured to obtain (e.g. receive; as part of e.g. an operation S210 of the method 200) values for one or more parameters for each battery pack 132-1 to 132-N. Example parameters include voltage, current, State-of-Charge (SoC) and internal impedance. Voltage may for example include battery pack voltage $VP_i$ and/or battery pack link voltage $VL_i$ (wherein battery pack voltage $VP_i$ is measured before the contactor 133-i, and wherein battery pack link voltage $VL_i$ is measured after the contactor 133-i, as indicated in FIG. 1). Current may for example include battery pack current $I_i$. The SoC for each battery pack, i.e. $SoC_i$, may be estimated using conventional methods, either by some other entity that provides $SoC_i$ to the device 100 as part of the inputs 120, or by the device 100 itself which is then configured to estimate $SoC_i$ for each battery packs based on one or more other values of the inputs 120, such as e.g. based on battery pack voltage $VP_i$ and similar. Internal impedance $Z_i$ of a battery pack may for example be estimated using conventional methods. In addition to such parameters and their values, the device 100 may, in some examples, be configured to also receive and/or determine e.g. traction voltage $VT$, which is the voltage delivered at input ports of the box 140 and which is not specific for each battery pack 132-1 to 132-N. Other example parameters are of course also envisaged.

The device 100 is further configured to determine (as part of e.g. an operation S220 of the method 200), for at least one parameter of the one or more parameters, a deviation $\delta_i$ of the value $P_i$ of the at least one parameter for a first battery pack (i.e. battery pack 132-i) from an aggregate function value $S_i$. The aggregate function value $S_i$ is formed based on values $P_{j\neq i}$ of at least one parameter of one or more other battery packs of the ESS 130, e.g. of one or more battery packs 132-j

where $j \neq i$. For example, the aggregate function $S_i$ may be defined as a function $f$ of the values of $P_{j \neq i}$, i.e. $S_i = f(\{P_{j \neq i}\})$.

For example, an aggregate function may be an average/mean, in which case e.g.

$$S_i = \frac{1}{N-1} \sum_{j \neq i} P_j.$$

In another example, the aggregate function may be a minimum or maximum, in which case e.g.

$$S_i = \min_{j \neq i} P_j$$

or

$$S_i = \max_{j \neq i} P_j.$$

Other examples of aggregate functions may include median, a sum, a standard deviation, or any other function which combines one or more values of one or more parameters from one or more of the other battery packs than the battery pack 132-i. In general, independent of what specific aggregate function or functions that is/are used, the deviation $\delta_i$ may be calculated as

$$\delta_i = |P_i - S_i|,$$

$$\delta_i = P_i - S_i,$$

or similar.

In some examples, it may be envisaged that the value or values of also the first battery pack are included as part of the aggregate, such that $S_i = f(\{P_j\})$.

For example, one parameter may be battery pack voltage $V_i$, and the aggregate function may generate the average/mean battery pack voltage of all battery packs not including the first battery pack, i.e. $S_i = (\Sigma_{j \neq i} V_j)/(N-1)$. Comparing the battery pack voltage of the first battery pack against the average battery pack voltage of the other packs may provide an indication that the first battery pack is either charging or discharging at a slower rate than the other battery packs, which may indicate that there is a power path fault pertinent to the first battery pack.

As another example, one parameter may be battery pack current $I_i$, and the aggregate function may generate the average/mean battery pack current for all other battery packs, i.e. $S_i = (\Sigma_{j \neq i} I_j)/(N-1)$. Comparing the battery pack current of the first battery pack against the average battery pack current of the other packs may provide an indication that the first battery pack is either charging or discharging at a slower rate than the other battery packs, and/or e.g. that there is an issue with contact resistance or similar for the first battery pack, which may indicate that there is a power path fault pertinent to the first battery pack.

As another example, one parameter may be battery pack link voltage $VL_i$, and the aggregate function may generate the average/mean battery pack link voltage for all other battery packs, i.e. $S_i = (\Sigma_{j \neq i} VL_j)/(N-1)$. A deviation in battery pack link voltage for the first battery pack against the other battery packs may for example indicate that there is some issue with the connector/contactor 133-i or similar, which may be assumed as part of a power path fault for that first battery pack.

As another example, one parameter may be battery pack SoC, $SoC_i$, and the aggregate function may generate the average/mean battery pack SoC for all other battery packs, i.e. $S_i = (\Sigma_{j \neq i} SoC_j)/(N-1)$. Also here, the SoC of the first battery pack changing in a slower or faster pace than the other pack may indicate a power path fault.

As another example, one parameter may be battery pack internal impedance $Z_i$, and the aggregate function may generate the average/mean battery pack internal impedance for all other battery packs, i.e. $S_i = (\Sigma_{j \neq i} Z_j)/(N-1)$. A different battery pack internal impedance may indicate a power path fault pertinent to the first battery pack.

It is also envisaged that multiple parameters and their values may be combined, for the first battery pack and/or for the other battery packs. For example, in one example, a difference between battery pack link voltage $VL_i$ and battery pack voltage $VP_i$ may be considered, and the aggregate function may generate the average/mean such difference for all other battery packs, i.e. $S_i = (\Sigma_{j \neq i} |VL_j - VP_j|)/(N-1)$. If the difference between the battery pack line voltage and battery pack voltage for the first battery pack is deviating from the same difference for the other battery packs, this may indicate that there is a power path fault pertinent to the first battery pack.

It is also envisaged that different parameters or sets of parameters may be considered for the first battery pack and for the other battery packs. For example, in one example, a difference between battery pack link voltage $VL_i$ and battery pack voltage $VP_i$ may be considered for the first battery pack, while the aggregate function may generate e.g. the average/mean of a difference between traction voltage $VT$ and battery pack voltage $VP_j$ for the other battery packs. For example, it may be that $S_i = |VT - (\Sigma_{j \neq i} VP_j)/(N-1)|$. It may be assumed that the link voltage of a battery pack should be somewhat similar to the traction voltage $VT$, at least if the battery packs are connected in parallel, and such an aggregate function may thus be used to detect when there is an issue with the first battery pack indicated by its battery pack voltage $VP_i$ and battery pack link voltage $VL_i$ deviating from the aggregate function value.

In general, it is envisaged that any combination of one or more parameter values for the first battery pack may be compared to any combination of one or more parameter values for the other battery packs, wherein the latter includes at least one aggregate function of at least one parameter for the other battery packs.

For example, a combination $\tilde{P}_i$ of one or more parameter values for the first battery pack may be determined, as a function $g$ of one or more parameter values $P_i^{(l)}$ (where $l$ is an integer indicating the $l$:th such parameter value), i.e. such that $\tilde{P}_i = g\left(\left\{P_i^{(l)}\right\}\right)$.

Likewise, an aggregate function $\tilde{S}$ may be defined as a function h of one or more parameter values for the other battery packs, i.e. as $\tilde{S}_i = h\left(\left\{P_{j\neq i}^{(k)}\right\}\right)$, or even $\tilde{S}_i = h\left(\left\{P_j^{(k)}\right\}\right)$, where $k$ is an integer indication the k:th such parameter for the other battery packs. One or more deviations $\delta_i^{(a)}$ for the first battery pack may thus be calculated, where $a$ is an integer indicating the $a$:th such deviation, e.g. as

$$\delta_i^{(a)} = b\left(\tilde{P}_i, \tilde{S}_i\right),$$

where b is a function including at least some difference between $\tilde{P}_i$ and $\tilde{S}_i$.

The device 100 is further configured to determine (as part of e.g. an operation S230 of the method 200) that the deviation $\delta_i$ (or deviations $\delta_i^{(a)}$) is beyond a first threshold value A (or beyond respective first threshold values $\Lambda^{(a)}$). Further, the device 100 is configured to detect (as part of e.g. an operation S250 of the method 200) that there is a power path fault pertinent to the first battery pack 132-i, in response to determining that the deviation/deviations is/are beyond the (respective) first threshold(s) A or $\Lambda^{(a)}$.

For example, this may include determining a deviation of a battery pack current $I_i$ of the first battery pack 132-i from an aggregate function (e.g. average) of battery pack currents for the other battery packs, i.e. by determining that

$$\delta_i = |I_i - S_i|,$$

where $S_i = (\Sigma_{j\neq i} I_j)/(N-1)$. A power path fault may then be detected in response to determining/noticing that this deviation is beyond a first threshold value A, i.e. by determining that

$$\delta_i > \Lambda.$$

Similar determinations may of course also be performed for other parameters than current, such as e.g. for voltage, SoC and/or internal impedance as described and exemplified earlier herein.

In some examples, the device 100 may be further configured to take into account values of the various one or more parameters (of the first battery pack and/or of the other battery packs) for multiple time instances, e.g. as part of forming time-averages of the one or more parameter values over time in order to e.g. reduce the effect of noise and/or outlier values that may not necessarily indicate that there is a power fault.

For example, for a parameter $P_i$, a time average $P_i[L]$ may be formed taking into account $L$ time-instances of the value of the parameter $P_i$. For example, the time average may be a moving time average, in which the $L$ last recorded/obtained time-instance values of the parameter are considered. For example, it may be assumed that

$$P_i[L] = \frac{1}{L}\sum_{\tau=t-L+1}^{t} P_i(\tau),$$

where $P_i(\tau)$ is the value of the parameter $P_i$ at discreet time instance $\tau$. Other ways of combining multiple time-instance values of the parameter is of course also possible, to provide other types of (time-)filtering operations.

In some examples, the values $\tilde{P}_i$ and/or $\tilde{S}$ may then be based on such filtered values, such as e.g.

$$\tilde{P}_i = g\left(\left\{P_i^{(a)}[L_a]\right\}\right), \tilde{S}_i[L] = h\left(\left\{P_{j\neq i}^{(a)}[L]\right\}\right)$$

, and/or e.g. $\tilde{S}_i = h\left(\left\{P_{j\neq i}^{(a)}[L_a]\right\}\right)$ and similar, where $L_a$ indicates that the considered number of time instances may not necessarily be the same for each parameter or parameter combination of $\tilde{S}_i$.

For example, using battery pack current $I_i$ as one example parameter of interest, the device 100 may determine $I_i[15t]$ (e.g. a time average of the last 15 time instances recorded) and e.g. $S_i[15t] = (\Sigma_{j\neq i}I_j[15t])/(N-1)$, and detect a power path fault by noticing that e.g. $\delta_i = |I_i[15t] - S_i| > \Lambda$, or similar.

As another example, the device 100 may determine $\tilde{P}_i = |VL_i[15t] - VP_i[15t]|$ and

$$\tilde{S}_i = \left|S_i^{(1)}[15t] - S_i^{(2)}[15t]\right|,$$ where

$$S_i^{(1)}[15t] = \left(\Sigma_{j\neq 1}VL_j[15t]\right)/(N-1)$$ and

$S_i^{(2)} = (\Sigma_{j\neq i}VP_j[15t])/(N-1)$, and detect a power path fault by noticing that e.g. $\delta_i = \tilde{P}_i - \tilde{S}_i > \Lambda$.

As envisaged herein, with reference to time-averaging or considering of multiple time-instances, it may of course also be possible to e.g. define the aggregate function values as

$$S_i[L] = \frac{1}{L} \sum_{\tau=t-L+1}^{t} S_i(\tau),$$

wherein $S_i(\tau) = (\Sigma_{j \neq i} P_j(\tau))/(N-1)$ is the aggregate function calculated using parameter values $P_j(\tau)$ at time-instance $\tau$. In many situations, it may be assumed that this is the same as if instead calculating the aggregate function as

$$S_i[L] = \frac{1}{N-1} \left( \sum_{j \neq i} P_j[L] \right).$$

In some examples, the device 100 may be configured to output one or more signals 122 in response to determining/detecting the power path fault. For example, the device 100 may be configured to control the contactor 133-i of the first battery pack 132-i in order to cause a disconnection of the latter from the ESS 130. In some examples, this may include to first, before opening the contactor 133-i, controlling the ESS 130 in order to reduce or eliminate a current through the contactor 133-i before such opening, to reduce or avoid contactor wear due to e.g. arching or similar. As another example, the device 100 may be configured to output a warning signal to an operator of the ESS 130 in response to detecting the power path fault, which may e.g. be a signal (such as a visual or audio) signal to a driver a vehicle using the ESS 130, or similar. Such actions may form part of e.g. the operation S250 of the method 200.

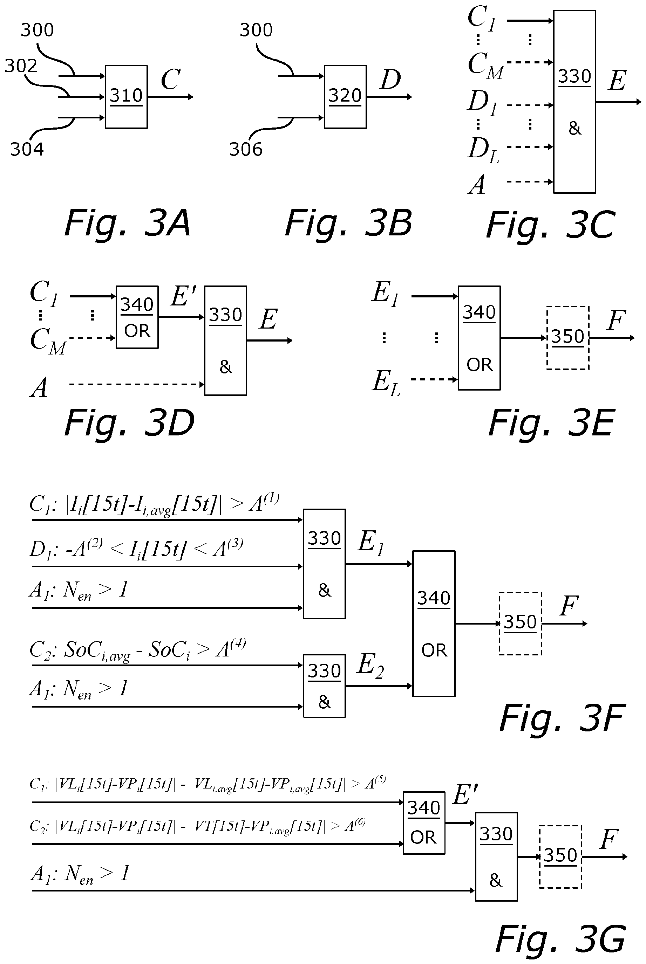

In general, as will now be described in more detail with reference also to FIGS. 3A to 3G, the parameter values and the aggregate function(s) formed based thereon may be used to form conditions that must be satisfied in order to assume that there is a power path fault. This may be achieved by the device 100 implementing one or more logic blocks.

**FIG. 3A** schematically illustrates a logic block 310 used to form such a condition. The block 310 receives one or more parameter values 300 for the first battery pack, one or more parameter values 302 for one or more of the other battery packs, and e.g. one or more first threshold values 304 that will be used to form a condition C that is then output from the block 310 and sent further down the processing chain. For example, value(s) 300 may include $V_i$ or e.g $V_i[L]$; value(s) 302 may include $S_i$, $S_i[L]$, $\bar{S}_i$ or similar; and value(s) 304 may include e.g. traction voltage $VT$. Here, it is assumed that the block 310 is not responsible for calculating these values, but only receives the values and combines them into the condition C. Calculation of the values may e.g. be performed by other parts of the device 100.

**FIG. 3B** schematically illustrates another logic block 320 that is configured to receive the one or more parameter values 300 for the first battery pack, and one or more second threshold values 306. Based on the value(s) 300 and 306, the block 320 forms and outputs an additional condition D that is sent further down the processing chain. The condition $D$ is thus only related to the one or more parameter values of the first battery pack, and does not take into account e.g. any aggregate function values based on parameter values of the other battery packs. This may provide an improved detection of power path faults, as it may be confirmed that the deviation of the first battery pack is e.g. not due to something being wrong with all or some of the other battery packs. The condition $D$ may for example require that the parameter (or time-averaged parameter) value of the first battery pack is above the threshold value 306, or below the threshold value 306, or e.g. that the parameter value is bounded by (i.e. between) two threshold values 306. Requiring that the parameter(s) 300 are bounded by the one or more threshold values 306 may for example be performed by the device as part of an optional operation S240 of the method 200, as indicated in FIG. 2.

**FIG. 3C** schematically illustrates another logic block 330 that is configured to receive one or more conditions $C_1$ to $C_M$ (where $M$ is an integer indicating the number of such conditions) as well as one or more additional conditions $D_1$ to $D_{M'}$ (where $M'$ is an integer indicating the number of such additional conditions, from e.g. one or more of the corresponding blocks 310 and 320, respectively. Receiving of more than one condition $C$, and/or receiving of any additional conditions $D$ is optional. In addition, the block 330 may be further configured to also receive one or more conditions $A$ that is not pertinent to any specific battery pack. For example, a condition A may include whether there is more than one battery pack currently active/connected in the ESS 130, or similar. The block 330 is configured to combine the various conditions (in an and-wise fashion) to output an output condition $E$. For example, the block 330 may be configured to output $E = true$ if all of its input conditions are true, and otherwise to output $E = false$, and similar.

**FIG. 3D** schematically illustrates another logic block arrangement that may be used/implemented by the device 100. Here, a block 340 is configured to receive at least one condition $C_1$ to $C_M$, from e.g. one or more logic blocks 320 and to, in an or-wise fashion, output an intermediate output condition $E'$. For example, the block 340 may be configured to output $E' = true$ if any one of $C_1$ to $C_M$ is true, and otherwise output $E' = false$. A block 330 then combines, in an and-wise fashion, the intermediate output condition $E'$ with one or more additional conditions $A$ as described above, such that an output $E$ is true if both of $E'$ and the additional one or more conditions $A$ are true.

**FIG. 3E** schematically illustrates another logic block arrangement, wherein a block 340 receives as input one or more output conditions $E_1$ to $E_O$ (where $O$ is an integer indicating the number of such received conditions) from e.g. one or more of the logic blocks or logic block arrangements illustrated in FIGS. 3C and 3D, and outputs (in an or-wise fashion) an output condition $F$ if at least one of the input conditions $E_1$ to $E_O$ are true. As also illustrated in FIG. 3E, an optional delay block 350 may be added which requires that for F to be true, the output from the block 340 should have remained true for at least a plurality of consecutive time instances, in order to e.g. avoid or reduce the risk of $F$ being true due to noise in any of the conditions $E_1$ to $E_O$ (inherently resulting from noise in any of the parameter values 300 and/or 302).

**FIG. 3F** schematically illustrates one possible combination of such logic blocks. Here, it is assumed that a first condition $C_1$ has been formed, requiring e.g. that the time-average battery pack current for the first battery pack over the last 15 time-instances deviates from the aggregate mean time-averages (also over the last 15 time-instances) for the other battery packs with more than $\Lambda^{(1)}$ Amperes (A). Phrased differently, $C_1$ requires that $|I_i[15t] - I_{i,avg}[15t]| > \Lambda^{(1)}$, where $I_{i,avg}[15t] = S_i[15t] = (\Sigma_{j \neq i} I_j[15t])/(N-1)$. Here, the use of 15 time-instances to create an average is of course only one out of many possible examples, and it is envisaged that e.g. whether to use a time-average, the exact length of such a time-average, as well as e.g. the exact value of the threshold value parameter $\Lambda^{(1)}$ can be modified/selected as desired depending on e.g. the exact configuration of the battery packs and ESS.

There is also a second, additional condition $D_1$ which requires that $\Lambda^{(2)} < I_i[15t] < \Lambda^{(3)}$, i.e. that the time-average (during the last 15 time-instances) of the battery pack current for the first battery pack alone should stay within the interval $[\Lambda^{(2)}, \Lambda^{(3)}]$, where for example $\Lambda^{(2)} = -\Lambda^{(3)}$. This may help to e.g. eliminate deviations and thus fulfillment of the condition $C_1$ based on e.g. one or more issues with the other battery packs, and similar. For example, it may be assumed that during normal use, an average current drawn from a battery pack is larger than A (3) in magnitude, and that the current of a particular battery pack suddenly reading below $\Lambda^{(3)}$ in magnitude is thus an indication of a power path fault. To avoid triggering a power path fault in a situation when all battery packs happen to draw/provide little current, fulfillment of both conditions $C_1$ and $D_1$ is thus required. In addition, an extra condition A requiring there to be more than one battery pack of the ESS 130 enabled, i.e. $N_{en} > 1$ where $N_{en}$ is an integer indicating the current number of enabled battery packs, is also required to avoid e.g. triggering/-detecting a power path fault when there are no or only a single battery pack enabled.

In addition, optionally, there is also a check whether a second condition $C_2$ requiring the SoC of the first battery pack being less than $\Lambda^{(4)}$ (%) below the average SoC of the other battery packs, i.e. such that $C_2$ requires that $SoC_{i,avg} - SoC_i > \Lambda^{(4)}$, where e.g. $SoC_{i,avg} = S_i = (\Sigma_{j \neq i} SoC_j)/(N-1)$. This may serve as an indication that the first battery pack is discharging quicker than the other packs (or e.g. not discharging at all), or e.g. charging slower than the other packs (or e.g. not charging at all), depending on whether the ESS 130 is currently discharging or charging as a whole. This may thus indicate that there is something wrong with the first battery pack.

The two blocks 330 combines their respective input conditions in an and-wise fashion, and output respective conditions $E_1$ and $E_2$. The block 340 combines the conditions $E_1$ and $E_2$ in an or-wise fashion, and outputs a condition $F$ if at least one of $E_1$ and $E_2$ is true, thus indicating that there is a power path fault. As explained earlier, there may be an optional delay block 350 requiring that the output from the block 340 remains true for at least a predefined number of time-instances. FIG. 3G serves to illustrate that as envisaged herein, requirements that there are deviations at least one of multiple parameters and there values can be required in order to detect/assume that there is a power path fault, e.g. by requiring deviations in at least one of battery pack current and SoC as in this particular example.

**FIG. 3G** schematically illustrates another example configuration of logic blocks. Here, there is a first condition $C_1$ requiring that a magnitude of a difference between the battery pack link voltage and battery pack voltage for the first battery pack, when time-averaged over the last 15 time-instances (where "15" is also here only used for example purposes, and may be tuned/altered as desired), is at least $\Lambda^{(5)}$ (Volts, V) larger than a magnitude of the same parameters but aggregated (and time-averaged) over the other battery packs. Phrased differently, $C_1$ requires that $|VL_i[15t] - VP_i[15t]| - |VL_{i,avg}[15t] - VP_{i,avg}[15t]| > \Lambda^{(5)}$, where e.g.

$$\left| VL_{i,avg}[15t] - VP_{i,avg}[15t] \right| = \tilde{S}_i[15t]$$

$$= \left| \frac{\sum_{j \neq i} VL_j[15t]}{N-1} - \frac{\sum_{j \neq i} VP_j[15t]}{N-1} \right|.$$

A second condition $C_2$ requires that the magnitude of the difference between the battery pack link voltage and battery pack voltage for the first battery pack, when time-averaged over the last 15 time-instances (where "15" is only one of many possible examples), is at least $\Lambda^{(6)}$ V larger than a magnitude of a difference between the traction voltage $VT$ and the aggregate (time-averaged) battery pack voltage of the other battery packs). Phrased differently, $C_2$ requires that $|VL_i[15t] - VP_i[15t]| - |VT[15t] - VP_{i,avg}[15t]| > \Lambda^{(6)}$, where e.g.

$$\left| VT[15t] - VP_{i,avg}[15t] \right| = \tilde{S}_i[15t]$$

$$= \left| \frac{1}{15} \sum_{\tau=t-15+1}^{t} \left( VT(\tau) - \frac{\sum_{j \neq i} VP_j(\tau)}{N-1} \right) \right|,$$

or similar, and where e.g. $\Lambda^{(5)} = \Lambda^{(6)}$. FIG. 3G serves to illustrate that as envisaged herein, the various conditions used for detected power path faults may be more than just simple comparison of one single parameter and its value against one single aggregate of the same parameter for the other packs. Instead, by use of logic blocks as described herein, more complex conditions may be constructed and evaluated in combination. It may also, as shown in FIG. 3C be required that deviations are detected for multiple different parameters of the first battery pack (vis-à-vis their corresponding aggregates for the other battery packs), such as e.g. a requirement that there are deviations for both battery pack voltage and battery pack current; for both battery pack voltage and battery pack SoC; for both battery pack current and battery pack SoC, or any other combination of more than two of e.g. voltage, current, SoC, and/or e.g. battery pack internal impedance or similar. Denoting voltage with V, current with I, internal impedance with Z, it may thus be required that at least one of the following combinations of such parameters are true to detect a power path fault: i) V and I; ii) V and SoC; iii) V and Z; iv) I and SoC; v) I and Z; vi) SoC and Z; vii) V and I and SoC; viii) V and I and Z; ix) V and SoC and Z; x) I and SoC and Z; and xi) V and I and SoC and Z, in addition to of course xii) only V; xiii) only I; xiv) only SoC; and xv) only Z.

The device 100 may be included as part of a battery management system (BMS, not shown), or e.g. as part of a multi-battery pack monitoring system, or similar.

The battery pack voltage for the first battery pack being lower than (or higher than) the aggregate (e.g. mean) battery pack voltage of the other battery packs by a certain threshold may be used as one fault condition. The battery pack current for the first battery pack being lower than (or higher than) the aggregate (e.g. mean) battery pack current of the other battery packs by a certain threshold may be used as another fault condition. The SoC of the first battery pack being lower than (or higher than) the aggregate (e.g. mean) SoC of the other battery packs may be used as yet another fault condition. The battery pack internal impedance of the first battery pack being lower than (or higher than) the aggregate (e.g. mean) internal impedance of the other battery packs may be used as yet another fault condition, and similar. The device 100 may require only a single such condition to be true in order to detect the power path fault, or require that at least two (e.g. any combination of the fault conditions) be true to detect the power path fault, e.g. in accordance with any of the items i) through xv) listed above.

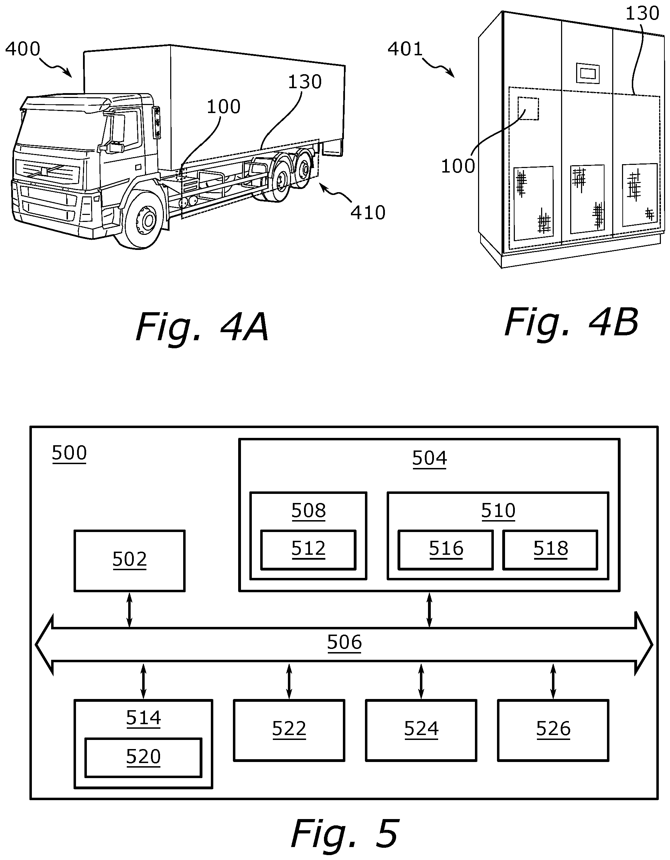

**FIG. 4A** schematically illustrates an example vehicle 400 as envisaged herein, which includes the ESS 130 and thereby the device 100. In this particular example, the vehicle is an electric heavy(-duty) vehicle in form of a truck 400. The ESS 130 may for example be used to power any electrical circuitry of the vehicle 400. In some examples, the ESS 130 is configured to power an electrical propulsion/traction 410 of the vehicle 400, including one or more electrical machines such as the electrical machine 140 illustrated in FIG. 1. With the device 100, power path faults in the ESS 130 may be detected more reliably, and the vehicle 400 can thus be made more safe and more reliable. Although illustrated herein using a truck 400, a "vehicle" as envisaged herein may be any type of electric or hybrid-electric vehicle, not necessarily limited to road vehicles. The same solution, including the use of the improved device 100, may e.g. be used in electric marine vessels, electric airplanes, or in any vehicle and/or vessel in which one or more energy storage elements (i.e. batteries and/or battery elements) are included as part of an ESS and are used to power an electric propulsion, or other electrical system, of the vehicle, and wherein accurate and reliable detection of power path faults is desirable. The device 100 and method 200 as envisaged herein may also be used for low-voltage ESS, such as e.g. batteries for powering lighting or other functionality of the vehicle than the propulsion, or similar.

**FIG. 4B** schematically illustrates another example of an entity including an ESS as envisaged herein, here in form of a battery bank 401 configured to deliver (or receive) energy to (or from) a power grid, as part of e.g. a backup- and/or ancillary service. The battery bank 401 includes the ESS 130 and thereby the device 100. The battery bank 401 may for example be installed as part of the power grid itself, and/or be provided e.g. as part of a building or similar. The device 100 (and method 200 performed thereby) allows improved detection of power path faults, thus making the battery bank 401 safer to operate. The battery bank 401 may for example include one or more energy storage elements that have been harvested from e.g. an electric vehicle, representing so-called "second use" wherein e.g. battery packs that are no longer considered useful in electric vehicles may still be used in other, less demanding applications, such as home energy storage solutions, off-grid solutions, grid solutions, and similar. In particular, FIG. 4B and the battery bank 401 serve to illustrate that the device 100 (and method 200 performed therein) as envisaged herein is not necessarily applicable only to electric (heavy) vehicles, but may find use in any situation in which there is an ESS and a need for reliable power path fault detection.

**FIG. 5** schematically illustrates a diagram of an example computer system 500 for implementing examples disclosed herein, such as e.g. for implementing all or part of the device 100. The computer system 500 is adapted to execute instructions from a computer-readable medium to perform these and/or any of the functions or processing described herein. The computer system 500 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 500 may include any collection of devices that individually or jointly execute a set (or multiple sets) of instructions to perform any one or more of the methodologies discussed herein, such as all or part of the method 200. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 500 may comprise at least one computing device or electronic device capable of including firmware, hardware, and/or executing software instructions to implement the functionality described herein. The computer system 500 may include processing circuitry 502 (e.g., processing circuitry including one or more processor devices or control units), a memory 504, and a system bus 506. The computer system 500 may include at least one computing device having the processing circuitry 502. The system bus 506 provides an interface for system components including, but not limited to, the memory 504 and the processing circuitry 502. The processing circuitry 502 may include any number of hardware components for conducting data or signal processing or for executing computer code stored in memory 504. The processing circuitry 502 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 502 may further include computer executable code that controls operation of the programmable device.

The system bus 506 may be any of several types of bus structures that may further interconnect to a memory bus (with or without a memory controller), a peripheral bus, and/or a local bus using any of a variety of bus architectures. The memory 504 may be one or more devices for storing data and/or computer code for completing or facilitating methods described herein. The memory 504 may include database components, object code components, script components, or other types of information structure for supporting the various activities herein. Any distributed or local memory device may be utilized with the systems and methods of this description. The memory 504 may be communicably connected to the processing circuitry 502 (e.g., via a circuit or any other wired, wireless, or network connection) and may include computer code for executing one or more processes described herein. The memory 504 may include non-volatile memory 508 (e.g., read-only memory (ROM), erasable programmable read-only memory (EPROM), electrically erasable programmable read-only memory (EEPROM), etc.), and volatile memory 510 (e.g., random-access memory (RAM)), or any other medium which can be used to carry or store desired program code in the form of machine-executable instructions or data structures and which can be accessed by a computer or other machine with processing circuitry 502. A basic input/output system (BIOS) 512 may be stored in the non-volatile memory 508 and can include the basic routines that help to transfer information between elements within the computer system 500.

The computer system 500 may further include or be coupled to a non-transitory computer-readable storage medium such as the storage device 514, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 514 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 514 and/or in the volatile memory 510, which may include an operating system 516 and/or one or more program modules 518. All or a portion of the examples disclosed herein may be implemented as a computer program 520 stored on a transitory or non-transitory computer-usable or computer-readable storage medium (e.g., single medium or multiple media), such as the storage device 514, which includes complex programming instructions (e.g., complex computer-readable program code) to cause the processing circuitry 502 to carry out actions described herein. Thus, the computer-readable program code of the computer program 520 can comprise software instructions for implementing the functionality of the examples described herein when executed by the processing circuitry 502. In some examples, the storage device 514 may be a computer program product (e.g., readable storage medium) storing the computer program 520 thereon, where at least a portion of a computer program 520 may be loadable (e.g., into a processor) for implementing the functionality of the examples described herein when executed by the processing circuitry 502. The processing circuitry 502 may serve as a controller or control system for the computer system 500 that is to implement the functionality described herein.

The computer system 500 may include an input device interface 522 configured to receive input and selections to be communicated to the computer system 500 when executing instructions, such as from a keyboard, mouse, touch-sensitive surface, etc. Such input devices may be connected to the processing circuitry 502 through the input device interface 522 coupled to the system bus 506 but can be connected through other interfaces, such as a parallel port, an Institute of Electrical and Electronic Engineers (IEEE) 1394 serial port, a Universal Serial Bus (USB) port, an IR interface, and the like. The computer system 500 may include an output device interface 524 configured to forward output, such as to a display, a video display unit (e.g., a liquid crystal display (LCD) or a cathode ray tube (CRT)). The computer system 500 may include a communications interface 526 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

In summary of all of the above, the present disclosure improves upon currently available technology in that provides a device/method capable of more accurate and reliable power path fault detection in an ESS. The improvement is generally obtained by considering not only parameters of a single battery pack (or other energy storage element), but by instead comparing e.g. a parameter of a first battery pack against e.g. an average (or other aggregate) of such a parameter for other battery packs of the ESS. In this way, more reliable detection of power path faults is obtained, as it is envisaged that a power path fault pertinent to the first battery pack will cause the parameter to deviate from the average/aggregate in a detectable way. This may reduce complications following from less-than-accurate such predictions, such as increase in temperature due to e.g. broken or dislocated connections between the first battery pack and e.g. a high-voltage junction/connection box and/or power inverter, that may otherwise result in unnecessary component wear or even risk igniting a fire or similar. By accurately detecting the power path fault, the relevant battery pack (or other energy storage element) may for example be disconnected from the ESS in order to avoid causing further harm.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

The following is an exemplifying list of examples envisaged herein:

Example 1: A device for power path fault detection in an energy storage system, ESS, the device including circuitry configured to: i) obtain, during charging or discharging of an energy storage system, ESS, values for one or more parameters for each energy storage element of a plurality of energy storage elements of the ESS; ii) determine, for at least one parameter of the one or more parameters, a deviation of the value of the at least one parameter for a first energy storage element of the plurality of energy storage elements from an aggregate function value, wherein the aggregate function value is formed based on values of at least one parameter of the one or more parameters for one or more other energy storage elements of the plurality of energy storage elements than the first energy storage element; iii) determine that the deviation is beyond a first threshold value and, in response thereto, detect a power path fault pertinent to the first energy storage element.

Example 2: The device of example 1, wherein determining the deviation includes taking into account values for the at least one parameter for the first energy storage element and/or for the one or more energy storage elements for multiple time instances.

Example 3: The device of example 1 or 2, wherein detecting the power path fault further includes determining that the value of the at least one parameter for the first energy storage element is either bounded by or beyond a second threshold value.

Example 4: The device of any one of examples 1 to 3, wherein the at least one parameter for the first energy storage element includes State-of-Charge, SoC.

Example 5: The device of any one of the preceding examples, wherein the at least one parameter for the first energy storage element includes voltage.

Example 6: The device of example 5, wherein the voltage is one or more of battery cell voltage, battery pack voltage, battery pack link voltage, and battery pack voltage to battery pack link voltage difference.

Example 7: The device of any one of the preceding examples, wherein the at least one parameter for the first energy storage element includes internal impedance.

Example 8: The device of example 7, wherein the internal impedance is or includes direct current internal resistance, DCIR.

Example 9: The device of any one of the preceding examples, wherein the at least one parameter for the first energy storage includes an impedance of an interconnect connecting the first energy storage element to one or more of the other one or more energy storage elements.

Example 10: The device of any one of the preceding examples, wherein the at least one parameter for the first energy storage element includes current.

Example 11: The device of any one of the preceding examples, configured to determine such a deviation for each of a plurality of different parameters or parameter combinations for the first energy storage element, and to detect the power path fault in response to determining that each of said deviations is beyond a respective first threshold value.

Example 12: The device of example 11, wherein the plurality of different parameters for the first energy storage element includes at least two of voltage, current, state-of-charge, SoC, and internal impedance.

Example 13: The device of any one of the preceding examples, wherein the aggregate function includes an average of the at least one parameter for the one or more other energy storage elements.

Example 14: The device of any one of the preceding examples, wherein the aggregate function includes a minimum or maximum of the at least one parameter for the one or more other energy storage elements.

Example 15: The device of any one of the preceding examples, wherein the plurality of energy storage elements is a plurality of battery packs.

Example 16: The device of any one of examples 1 to 14, wherein the plurality of energy storage elements is a plurality of battery cells.

Example 17: The device of any one of examples 1 to 14, wherein the plurality of energy storage elements is a plurality of battery modules.

Example 18: The device of any one of the preceding examples, further configured to, in response to detecting the power path fault, trigger or cause a disconnection of the first energy storage element.

Example 19: The device of any one of the preceding examples, furthered configured to, in response to detecting the power path fault, trigger or cause a warning signal to an operator of the ESS.

Example 20: An energy storage system, ESS, including a plurality of energy storage elements and the device of any one of the preceding examples for detecting a power path fault pertinent to at least one of said energy storage elements.

Example 21: A vehicle, including the energy storage system, ESS, of example 20.

Example 22: A computer-implemented method of detecting a power path fault in an energy storage system, ESS, the method including: i) obtaining, by processing circuitry of a computer system and during charging or discharging of an energy storage system, ESS, values for (same) one or more parameters for each energy storage element of a plurality of energy storage elements of the ESS; ii) determining, by the processing circuitry and for at least one parameter of the one or more parameters, a deviation of the value of the at least one parameter for a first energy storage element of the plurality of energy storage elements from an aggregate function value, including forming the aggregate function value based on values of at least one parameter of the one or more parameters for one or more other energy storage elements of the plurality of energy storage elements than the first energy storage element, and iii) determining a power path fault pertinent to the first energy storage element.

Example 23: A computer program product including computer program code for performing, when executed by processing circuitry, the method of example 22.

Example 24: A non-transitory computer-readable storage medium including instructions, which when executed by processing circuitry, cause the processing circuitry to perform the method of example 22.

## Claims

1. A device (100, 500) for power path fault detection in an energy storage system, ESS, the device comprising circuitry (110) configured to:

   i) obtain, during charging or discharging of an energy storage system, ESS, (130), values (120) for one or more parameters for each energy storage element of a plurality of energy storage elements (132-1 to 132-N) of the ESS;
   ii) determine, for at least one parameter of the one or more parameters, a deviation of the value of the at least one parameter for a first energy storage element (132-i) of the plurality of energy storage elements from an aggregate function value, wherein the aggregate function value is formed based on values of at least one parameter of the one or more parameters for one or more other energy storage elements of the plurality of energy storage elements than the first energy storage element;
   iii) determine that the deviation is beyond a first threshold value (A) and, in response thereto, detect a power path fault pertinent to the first energy storage element.

2. The device of claim 1, wherein determining the deviation comprises taking into account values for the at least one parameter for the first energy storage element and/or for the one or more energy storage elements for multiple time instances.

3. The device of claim 1 or 2, wherein detecting the power path fault further comprises determining that the value of the at least one parameter for the first energy storage element is either bounded by or beyond a second threshold value.

4. The device of any one of claims 1 to 3, wherein the at least one parameter for the first energy storage element comprises at least one of State-of-Charge, SoC; voltage; internal impedance; an impedance of an interconnect connecting the first energy storage element to one or more of the other one or more energy storage elements, and current.

5. The device of claim 4, wherein the voltage is one or more of battery cell voltage, battery pack voltage

($VP_i$), battery pack link voltage ($VL_i$), and battery pack voltage to battery pack link voltage difference ($VP_i - VL_i$).

6. The device of claim 4 or 5, wherein the internal impedance is or comprises direct current internal resistance, DCIR.

7. The device of any one of the preceding claims, configured to determine such a deviation for each of a plurality of different parameters or parameter combinations for the first energy storage element, and to detect the power path fault in response to determining that each of said deviations is beyond a respective first threshold value.

8. The device of claim 7, wherein the plurality of different parameters for the first energy storage element comprises at least two of voltage, current, state-of-charge, SoC, and internal impedance.

9. The device of any one of the preceding claims, wherein the aggregate function comprises at least one of an average, minimum and maximum of the at least one parameter for the one or more other energy storage elements.

10. The device of any one of the preceding claims, wherein the plurality of energy storage elements is a plurality of battery packs (132-1 to 132-N), battery cells and/or battery modules.

11. The device of any one of the preceding claims, further configured to, in response to detecting the power path fault, trigger or cause at least one of i) a disconnection of the first energy storage element and ii) a warning signal issued to an operator of the ESS.

12. An energy storage system, ESS, (130) comprising a plurality of energy storage elements (132-1 to 132-N) and the device (100) of any one of the preceding claims for detecting a power path fault pertinent to at least one (131-i) of said energy storage elements.

13. A vehicle, comprising the energy storage system, ESS, of claim 12.

14. A computer-implemented method (200) of detecting a power path fault in an energy storage system, ESS, the method comprising:

   i) obtaining (S210), by processing circuitry of a computer system and during charging or discharging of an energy storage system, ESS, values for one or more parameters for each energy storage element of a plurality of energy storage elements of the ESS;

ii) determining (S220), by the processing circuitry and for at least one parameter of the one or more parameters, a deviation of the value of the at least one parameter for a first energy storage element of the plurality of energy storage elements from an aggregate function value, comprising forming the aggregate function value based on values of at least one parameter of the one or more parameters for one or more other energy storage elements of the plurality of energy storage elements than the first energy storage element, and

iii) determining (S230), by the processing circuitry, that the deviation is beyond a first threshold value and, in response thereto, detecting (S250) a power path fault pertinent to the first energy storage element.

15. A non-transitory computer-readable storage medium comprising instructions, which when executed by processing circuitry, cause the processing circuitry to perform the method of claim 14.

Fig. 1

Fig. 2

## Fig. 3A

300
302
304
310
C

## Fig. 3B

300
306
320
D

## Fig. 3C

$C_1$
$C_M$
$D_1$
$D_L$
A
330
&
E

## Fig. 3D

$C_1$
$C_M$
340 OR
E'
330 &
E
A

## Fig. 3E

$E_1$
$E_L$
340 OR
350
F

## Fig. 3F

$C_1$: $|I_i[15t] - I_{i,avg}[15t]| > \Lambda^{(1)}$

$D_1$: $-\Lambda^{(2)} < I_i[15t] < \Lambda^{(3)}$

$A_1$: $N_{en} > 1$

330 &

$E_1$

$C_2$: $SoC_{i,avg} - SoC_i > \Lambda^{(4)}$

$A_1$: $N_{en} > 1$

330 &

$E_2$

340 OR

350

F

## Fig. 3G

$C_1$: $|VL_i[15t] - VP_i[15t]| - |VL_{i,avg}[15t] - VP_{i,avg}[15t]| > \Lambda^{(5)}$

$C_2$: $|VL_i[15t] - VP_i[15t]| - |VT[15t] - VP_{i,avg}[15t]| > \Lambda^{(6)}$

340 OR

E'

$A_1$: $N_{en} > 1$

330 &

350

F

*Fig. 4A*

*Fig. 4B*

*Fig. 5*

Europäisches
Patentamt

European
Patent Office

Office européen
des brevets

# EUROPEAN SEARCH REPORT

**Application Number**

EP 24 17 1373

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/333170 A1 (KIM YOUNG-MIN [KR] ET AL) 19 October 2023 (2023-10-19)<br>* paragraph [0002] *<br>* paragraph [0010] *<br>* paragraph [0013] - paragraph [0016] *<br>* paragraph [0059] *<br>* paragraph [0064] - paragraph [0065] *<br>* paragraph [0022] * | 1-15 | INV.<br>G01R31/00<br>G01R31/36<br>G01R31/389<br>G01R31/396<br>B60L3/00<br>H02J7/00 |
| X | US 2022/115878 A1 (KHOZIKOV VYACHESLAV [US] ET AL) 14 April 2022 (2022-04-14)<br>* paragraph [0016] - paragraph [0017] * | 1,14,15 | |
| X | US 2010/305792 A1 (WILK MICHAEL D [US] ET AL) 2 December 2010 (2010-12-02)<br>* paragraph [0015] - paragraph [0017] * | 1,14,15 | |
| A | US 2023/137625 A1 (SANKAVARAM CHAITANYA [US] ET AL) 4 May 2023 (2023-05-04)<br>* paragraph [0021] - paragraph [0023] * | 1-15 | |
| A | US 2022/255335 A1 (KHOZIKOV VYACHESLAV [US] ET AL) 11 August 2022 (2022-08-11)<br>* paragraph [0009] * | 1-15 | **TECHNICAL FIELDS SEARCHED (IPC)**<br><br>G01R |

The present search report has been drawn up for all claims

| Place of search | Date of completion of the search | Examiner |
|---|---|---|
| The Hague | 17 October 2024 | Régert, Tamás |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 17 1373

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2024

| Patent document cited in search report | | Publication date | Patent family member(s) | | Publication date |
|---|---|---|---|---|---|
| US 2023333170 | A1 | 19-10-2023 | CN | 116601508 A | 15-08-2023 |
| | | | EP | 4202464 A1 | 28-06-2023 |
| | | | JP | 7563862 B2 | 08-10-2024 |
| | | | JP | 2023538052 A | 06-09-2023 |
| | | | KR | 20220167847 A | 22-12-2022 |
| | | | US | 2023333170 A1 | 19-10-2023 |
| | | | WO | 2022265358 A1 | 22-12-2022 |
| US 2022115878 | A1 | 14-04-2022 | CN | 114336817 A | 12-04-2022 |
| | | | EP | 3982508 A1 | 13-04-2022 |
| | | | JP | 2022063228 A | 21-04-2022 |
| | | | US | 2022115878 A1 | 14-04-2022 |
| US 2010305792 | A1 | 02-12-2010 | US | 2010305792 A1 | 02-12-2010 |
| | | | WO | 2010138744 A2 | 02-12-2010 |
| US 2023137625 | A1 | 04-05-2023 | CN | 116061689 A | 05-05-2023 |
| | | | DE | 102022122597 A1 | 04-05-2023 |
| | | | US | 2023137625 A1 | 04-05-2023 |
| US 2022255335 | A1 | 11-08-2022 | CA | 3147556 A1 | 11-08-2022 |
| | | | CN | 114928123 A | 19-08-2022 |
| | | | EP | 4044394 A1 | 17-08-2022 |
| | | | JP | 2022123836 A | 24-08-2022 |
| | | | KR | 20220115785 A | 18-08-2022 |
| | | | TW | 202234785 A | 01-09-2022 |
| | | | US | 2022255335 A1 | 11-08-2022 |

EPO FORM P0459

For more details about this annex : see Official Journal of the European Patent Office, No. 12/82